# EUROPEAN PATENT SPECIFICATION

(11) **EP 0 380 119 B1**
(45) Date of publication and mention of the grant of the patent: **13.07.1994**
(21) Application number: 90101572.7
(22) Date of filing: 26.01.1990
(51) Int. Cl.: H01J 37/32, H05H 1/46

(54) **Microwave plasma processing apparatus**
Mikrowellen-Plasmabearbeitungsgerät
Appareil de traitement par plasma micro-ondes

(30) Priority: 26.01.1989 JP 16901/89
(43) Date of publication of application: 01.08.1990
(73) Proprietor: FUJITSU LIMITED, Kawasaki-shi, Kanagawa 211 (JP)
(72) Inventor: Fujimura, Shuzo, c/o Fujitsu Limited, Kawasaki-shi, Kanagawa 211 (JP)
(74) Representative: Sunderland, James Harry

(56) References cited:
- EP-A- 0 090 586
- EP-A- 0 115 970
- EP-A- 0 237 078
- US-A- 4 631 105
- JOURNAL OF THE ELECTROCHEMICAL SOCIETY. vol. 135, no. 9, September 1988, MANCHESTER, NEW HAMP, pp. 2338-2341 ; A. KALNITSKY et al. : "Characterization and optimization of a single wafer downstream plasma stripper"

## Description

The present invention relates to a microwave plasma processing apparatus, for example for use in processes for fabrication of semiconductor devices.

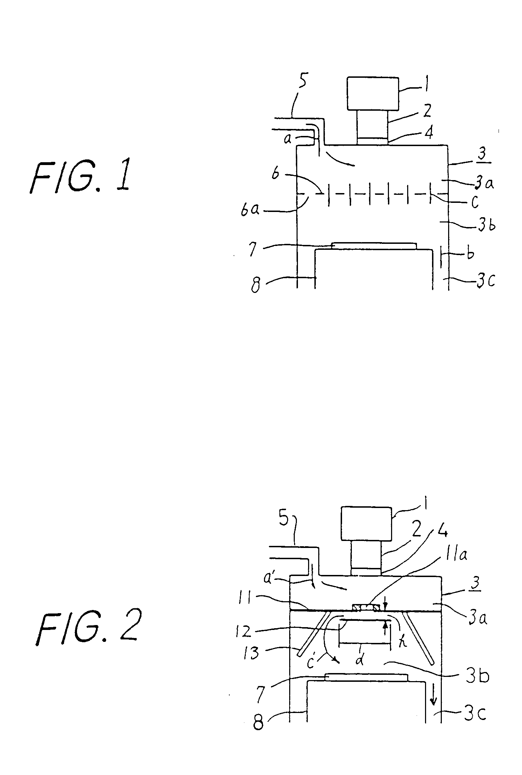

An improved type of microwave plasma processing apparatus has been disclosed in U.S. Patent No. 4512868 issued on 23rd April 1985 to Fujimura et al. (corresponding to Japanese Unexamined Patent Publication SHO 62-16424). The apparatus has a specific structure such that a reactive gas is introduced into a plasma generation chamber, microwave power is introduced into the plasma generation chamber, a plasma which comprises active species is generated in the reactive gas, the active species are introduced into a separate reaction chamber arranged adjacent to the plasma generation chamber, and a substrate is disposed and processed in the reaction chamber. An outline of the apparatus will be explained with reference to Fig. 1.

Fig. 1 is a schematic cross-sectional view of the microwave plasma processing apparatus. A microwave generator 1 supplies microwave power which is transmitted into a reactor 3 through a waveguide 2 and a window 4 which seals the reactor 3 vacuum tight but allows the microwave power to penetrate therethrough. A reactive gas including at least oxygen (O₂) flows into the reactor 3 through an inlet pipe 5 as shown by an arrow a. In the reactor 3, a plasma shield plate 6 made of aluminium is provided, dividing the reactor 3 into a plasma generation chamber 3a and a reaction chamber 3b. The plasma shield plate 6, which is sometimes called a shower head, has a plurality of small holes 6a. A substrate 7 is arranged on a stage 8 in the reaction chamber 3b. Gas after reaction is exhausted through an exhaust pipe 3c as shown by an arrow b.

The microwave power, delivered at a frequency of a few Gigahertz, excites the reactive gas within the plasma generation chamber 3a and generates plasma comprising active species. The uniformly diffused plasma in the plasma generation chamber 3a flows into the reaction chamber 3b through small holes 6a as shown by arrows c. However, most of the charged particles such as ions in the plasma remain in the plasma generation chamber 3a. The neutral active species flow into the reaction chamber 3b with uniform distribution.

A resist layer coated on a surface of the substrate 7 reacts with the active species, allowing performance of uniform etching or of an ashing process over the entire surface of the substrate 7.

For example, a mixed gas of oxygen (O₂) and carbon tetrafluoride (CF₄), mixed in the ratio of 8:2, is used as the reactive gas and microwave power of about 0.4 KW at 2.45 GHz is applied into the plasma generation chamber 3a. The reaction chamber 3b is evacuated down to about 40 Pa (0.3 Torr). A good result of an ashing process for the resist layer has been obtained.

Another improved microwave plasma processing apparatus has been disclosed in U.S. Patent No. 4718976 issued on 12th January 1988 to Fujimura (corresponding to Japanese Allowed Patent Publication SHO 62-1534). An outline of the structure thereof is shown in the schematic cross-sectional view of Fig. 2. In Figs. 1 and 2 the same reference signs designate the same or similar items. A plasma generation chamber 3a is separated from a reaction chamber 3b in a way similar to that shown in Fig. 1, but active species comprised in the plasma are introduced into the reaction chamber 3b through flow rate control means 11a (a conductance controller).

In Fig. 2, the conductance controller 11a is provided at the centre of a metallic, for example aluminium, plasma shield plate 11 which divides reactor 3 into the two sections: plasma generation chamber 3a and reaction chamber 3b. A circular gas diffusion plate 12 is arranged in the reaction chamber 3b. The plate has a diameter d and is located a predetermined distance h from the plasma shield plate 11 such that the plasma introduced through the conductance controller 11a can diffuse outwardly and uniformly after collision with the gas diffusion plate 12. Further, a funnel-shaped reflector 13 is provided outside the gas diffusion plate 12 and above a substrate 7. The reflector 13 functions to direct the plasma on to the substrate 7.

The reactive gas is introduced into the plasma generation chamber 3a from an inlet pipe 5 as shown by an arrow a'. The reactive gas is excited by microwave power, and the generated plasma flows into the reaction chamber 3b passing through the conductance controller 11a, and further diffuses on to the substrate 7 along a path shown by an arrow c'.

When the diameter d of the gas diffusion plate 12 and the distance h from the plasma shield plate 11 are set at optimum values, satisfactory results can be obtained.

Further, the following patent applications which are related to a microwave plasma processing apparatus have been filed by Fujimura et al.:-
U.S. Application No. 802332, filed on 27th November 1985 (corresponding to Japanese Unexamined Patent Publication SHO 61-131454 and EP-A-183561);
U.S. Application 24070 (U.S. Patent No. 4 987 284), filed on 10th March 1987 (corresponding to EP-A-0 237 078 and Japanese Unexamined Patent Publication SHO 62-213126).

The two applications mentioned above concern a structure for a microwave window which partitions a plasma generation chamber from a microwave waveguide.

In all the documentary references cited above, etching or ashing processes are indicated to be carried out using a reactive gas including oxygen. Because the plasma shield plate 6 or 11, shown in Figs. 1 and 2 respectively, is made of aluminium, the exposed surface of the plasma shield plate in the plasma generation chamber 3a reacts with the active species of the plasma, resulting in a reduction of the active species.

As a result, processing rate decreases gradually with increasing use of the apparatus, as compared with the rate obtained initially when the plasma shield plate is covered with a natural oxide film only.

In an experiment, wherein a reactive gas of O₂+CF₄ (8% CF₄ content) was used and microwave power of 1.5 KW at 2.45 GHz applied, an ashing rate of about 1.5 »m/min was initially obtained for a resist layer on a substrate, i.e. was obtained when the plasma shield plate had a natural oxide film only. However, after utilisation of the apparatus for about three months, with eight hours operation per day, the ashing rate decreased to 0.5 »m/min to (5000 Å/min), which is about 1/3 of the initial rate:

This phenomenon is observed even when the aluminium surface of the plasma shield plate is subjected to alumite treatment before use.

Thus, existing microwave plasma processing apparatus has a drawback in that processing capability per unit time gradually deteriorates with increasing utilisation of the apparatus.

US-A-4 631 105 discloses a plasma processing apparatus in which a perforated shield divides a reaction chamber into upper and lower regions. The perforated shield is made of electrically conductive material such as aluminium and if desired can be provided with a coating of dielectric material such as alumina or anodised aluminium.

According to the present invention, there is provided microwave plasma processing apparatus comprising a plasma generation chamber, in which plasma can be generated by irradiating microwave power into a reactive gas introduced into the plasma generation chamber, a reaction chamber, and a plasma shield plate separating the reaction chamber from the plasma generation chamber, the plasma shield plate being of electrically conductive material and having means, e.g. a hole therein, allowing active species of the plasma to flow from the plasma generating chamber into the reaction chamber, the plasma shield plate having a covering thereon;
characterised in that said covering is a separate cover member disposed on the surface of the plasma shield plate facing into the plasma generation chamber, and made of material which is inactive with respect to active species included in the plasma generated in the apparatus when in use.

An embodiment of the invention provides a microwave plasma processing apparatus which does not exhibit marked deterioration in processing capability over a long operating period.

An embodiment of the present invention provides microwave plasma processing apparatus which offers improved productivity with stable performance over a long period of time.

An embodiment of the invention provides a microwave plasma processing apparatus in which reaction of active species with a plasma shield plate is prevented.

An embodiment of the invention provides a microwave plasma processing apparatus in which the function of confining plasma in a plasma generation chamber is not lost and active species of the plasma are stably introduced into a reaction chamber.

Reference is made, by way of example, to the drawings, in which:-
Figs. 1 and 2 are schematic sectional views of prior art microwave plasma processing apparatuses,
Fig. 3 is a schematic sectional view of microwave plasma processing apparatus in accordance with a first embodiment of the present invention,
Fig. 4 is a schematic sectional view of microwave plasma processing apparatus in accordance with a second embodiment of the present invention,
Fig. 5 is a schematic sectional view of microwave plasma processing apparatus in accordance with a third embodiment of the present invention,
Fig. 6 is a schematic partial section view of microwave plasma processing apparatus in accordance with a fourth embodiment of the present invention in which the plasma generation chamber of the third embodiment is modified,
Fig. 7 is a sectional view of the detailed structure of microwave plasma processing apparatus in which features of the first and third embodiments are combined,
Figs. 8(a) and 8(b) are a sectional view and a bottom view respectively of a quartz cover member of the apparatus of Fig. 7, and
Fig. 9 is a sectional view of the detailed structure of a microwave plasma processing apparatus similar to the third embodiment of the present invention.

Throughout the Figures, the same reference signs designate and identify the same or similar parts.

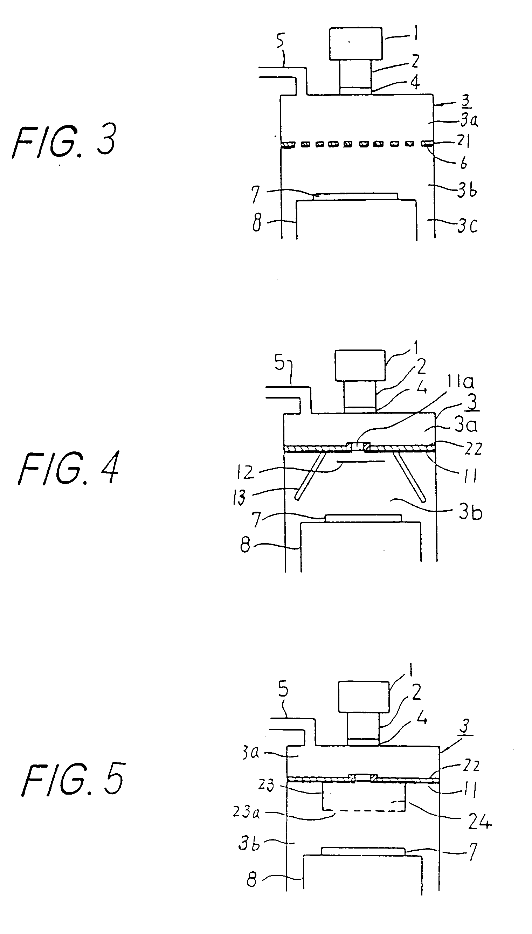

Fig. 3 is a schematic sectional view of microwave plasma processing apparatus in accordance with a first embodiment of the present invention. The apparatus shown in Fig. 3 is similar to that shown in Fig. 1 except that the entire surface of a plasma shield plate 6, in other words a shower head, facing into plasma generation chamber 3a is covered with a quartz cover 21 having a thickness of about 2 mm.

Herein, comparison tests, comparing the structure of Fig. 1 and that of Fig. 3 are explained. Tests were conducted under the conditions that a mixed gas of O₂ + N₂ (10% N₂ content) is used as a reactive gas, microwave power of 1.5 KW and 2.45 GHz is applied into the plasma generation chamber 3a, a degree of vacuum in the reaction chamber is maintained at about 133 Pa (1 Torr), a substrate is disposed on a stage 8 and heated up to 200^{o}C, and a resist layer on the substrate 7 is subjected to an ashing process for 60 to 90 seconds.

Using the apparatus of Fig. 1, tests were conducted for three months, ashing processes being repeated 500 times per day. At the beginning of the test sequence, an ashing rate of 1 »m/min was measured. However, at the end of the three-month test sequence, the ashing rate had deteriorated to 0.6 »m/min (6000 Å/min), which represents a 40% decrease over the initial ashing rate.

Similar tests were conducted using the same microwave plasma processing apparatus after the above test sequence. However, the structure of the apparatus was changed such that the quartz cover 21 was added on to the plasma shield plate 6 facing into the plasma generation chamber 3a. The ashing rate was increased to about 0.9 »m/min (9000 Å/min) from 0.6 »m/min (6000 Å/min) and maintained during almost the whole period of the subsequent three-month test sequence.

Therefore, a microwave plasma processing apparatus having stable or more stable performance over a long period of time, without reducing productivity, can be obtained by covering the entire surface of metallic plasma shield plate facing the plasma generation chamber with an insulating member such as the quartz cover 21.

Fig. 4 is a schematic sectional view of a second embodiment of the present invention. The second embodiment illustrates an application of the present invention to the structure of Fig. 2. In Fig. 4, a quartz cover 22 is arranged on a plasma shield plate 11 facing into a plasma generation chamber 3a. Improvements similar to those noted above with regard to Fig. 3 have been confirmed with regard to durability for the apparatus.

Fig. 5 is a schematic sectional view of a third embodiment of the present invention. In the third embodiment, the flat gas diffusion plate 12 of Fig. 4 is replaced by a cylindrical diffuser 23 having a plurality of holes 23a at a bottom surface thereof. The diffuser 23 is located on a downstream side of the reactive gas and fixed to the bottom surface of a plasma shield plate 11 and forming a diffusion chamber 24 for the plasma. A quartz cover 22 is arranged on the surface of the plasma shield plate 11 facing into the plasma generation chamber 3a. In this case, the reflector 13 of Fig. 4 is unnecessary.

In the third embodiment, active species and charged particles comprised in the plasma flow into a diffusion chamber 24 restricted by the cylindrical diffuser 23 and, after lingering for a while, the active species diffuse into reaction chamber 3b through a plurality of small holes 23a. Improvements similar to those mentioned above have been confirmed for the third embodiment.

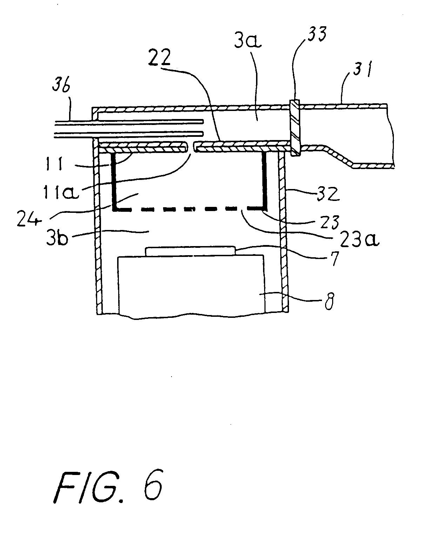

Fig. 6 shows a schematic sectional view of a fourth embodiment, in which the plasma generation chamber 3a of Fig. 5 is modified. Items other than the plasma generation chamber are the same as those of Fig. 5. One end of a waveguide 31 is integrated with the plasma generation chamber 3a and a reactor 32, and is partitioned off by a microwave window 33. The other end of the waveguide is connected to a microwave generator (not shown). A plasma shield plate 11, which forms a wall part of the plasma generation chamber 3a, has a through hole 11a of a predetermined diameter at the centre thereof.

A quartz cover 22 of 2 mm thickness is attached so as to cover the entire surface of the plasma shield plate facing into the plasma generation chamber. A gas inlet pipe 36 is lead through a side wall of the plasma generation chamber 3a so that the gas spouts near the through hole 11a of the plasma shield plate 11. A cylindrical gas diffuser 23 is fixed to the bottom surface of the plasma shield plate 11 and a substrate 7 is disposed on a stage 8, as shown in Fig. 5.

In the fourth embodiment, a region bound by the microwave window 33, the plasma shield plate 11 with the quartz cover 22 and walls forming an end portion of the reactor 32 constitutes the plasma generation chamber 3a. Active species and some of the charged particles comprised in plasma flow into a diffusion chamber 24 through the hole 11a. The diffusion chamber 24 is surrounded by the cylindrical diffuser 23 and, therefore, the active species of the plasma linger therein for a while and diffuse uniformly on to the substrate surface in a reaction chamber 3b through a plurality of small holes 23a. This type of the embodiment also shows satisfactory performance without deterioration in ashing rate over a long period of operation.

In the explanation of the above embodiments illustrated in Fig. 3 to Fig. 6, an ashing process using a reactive gas containing oxygen (O₂) has been considered. However, microwave plasma apparatus in accordance with the present invention may be applied for etching processes by utilising appropriate reactive gas.

It is necessary that the plasma generation chamber of microwave plasma processing apparatus is surrounded by walls of an electrically conductive material in order to confine microwave power introduced therein and the plasma generated thereby. Particularly, in case of processing a semiconductor substrate, the electrically conductive material is practically limited only to aluminium (Al).

In case a reactive gas in which carbon tetrafluoride (CF₄) or nitrogen (N₂) is mixed with oxygen (O₂), is used, active oxygen species exhibit recombination or reaction with an aluminium surface exposed to the plasma generation chamber. The surface of plasma shield plate of the previously proposed microwave plasma processing apparatus faces into and is exposed to the plasma generation chamber, and it has been demonstrated that the recombination or reaction of the active oxygen species with aluminium surface thereof results in a rapid decrease of etching or ashing capabilities and cannot be neglected.

An embodiment of the present invention employs a structure such that at least the surface of a plasma shield plate 6 or 11 facing the plasma generation chamber 3a is covered with the material which does not easily react with the plasma. In other words, the plasma shield plate is covered with material with which the active species of the plasma has or have a smaller recombination coefficient than with the conductive material, such as aluminium, of the plasma shield plate. Insulation material such as quartz and/or alumina ceramic is used as the material for covering the plasma shield plate. Furthermore, since the material is heated during processing operations, the thickness thereof should be greater than 1 mm, preferably about 2 mm.

If the surface of the plasma shield plate is covered with the insulating material by a coating or glazing method, the covering insulation layer may suffer cracking or peeling due to thermal stresses and may lose its function.

According to the embodiments of the present invention as shown in Figs. 3 to 6, the surface of aluminium plasma shield plate 6 or 11 facing into the plasma generation chamber 3a is covered with a cover member 21 or 22 respectively, and the cover member will not result in degradation of the confining function with respect to confinement of the plasma in the plasma generation chamber 3a and will not consume the active species.

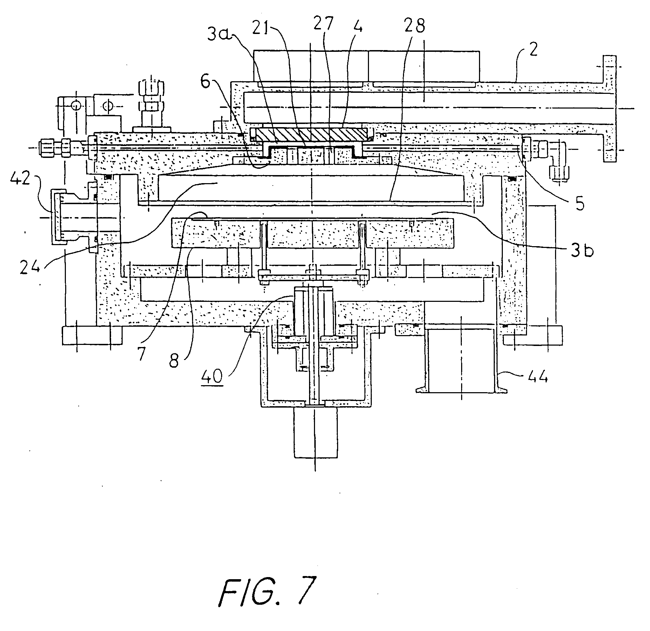

In the explanations of the first to fourth embodiments (Figs. 3 to 6) details of structure are omitted, for simplification. Fig. 7 is a cross-sectional view of an actual structure of microwave plasma processing apparatus in which features of the first embodiment (Fig. 3) and the third embodiment (Fig. 5) are combined.

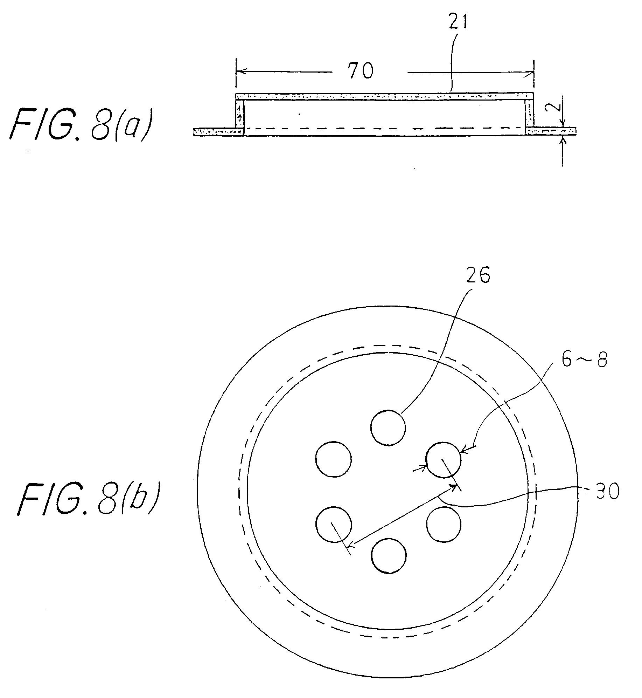

In Fig. 7, a microwave window 4 is arranged along a longitudinal wall direction of waveguide 2 and a reactive gas is introduced into a plasma generation chamber 3a flowing through an inlet pipe 5. A plasma shield plate 6 is formed of a thick aluminium plate and is covered with a cap-shaped quartz cover 21. The quartz cover 21 has a cross-sectional form as shown in Fig. 8(a), whilst Fig. 8(b) shows the cover 21 from below. The cover has six holes 26. Various dimensions of the cover are indicated (in millimetres) in Fig. 8(a) and 8(b). The plasma flows in a diffusion chamber 24 through the holes of quartz cover 21 and holes 27 of the plasma shield plate 6.

Charged particles such as ions and electrons entering into the diffusion chamber 24 are substantially removed by the plasma shield plate 6, and some charged particles partly entering therein are removed further by a diffusion plate 28 which provides a plurality of small holes (not shown). Active species flow from the diffusion chamber 24 uniformly on to a substrate 7 disposed on a stage 8. Vertical position of the substrate 7 can be adjusted by a mechanism 40. The gas is finally exhausted from an exhaust pipe 44. Progress of the plasma processing can be monitored through a window 42.

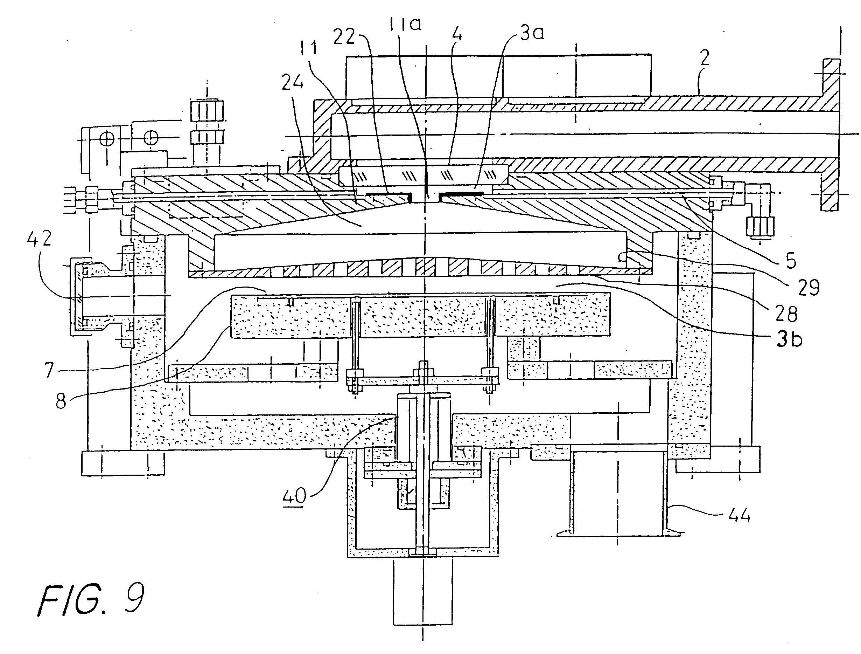

Fig. 9 shows a detailed structure of an actual microwave plasma processing apparatus in accordance with the third embodiment (Fig. 5). Arrangements of waveguide 2 and microwave window 4 are substantially the same as those shown in Fig. 7. A quartz cover 22 provides a single hole 11a at the centre thereof, and a region surrounded by a plasma shield plate 11, diffusion plate 28 and a side wall 29 forms a diffusion chamber 24. The remaining structure is substantially the same as that of Fig. 7 so detailed description is omitted here.

An embodiment of the present invention provides a microwave plasma processing apparatus for etching or ashing processes in relation to a semiconductor substrate, comprising a plasma generation chamber, into which a reactive gas and microwave power are introduced, a reaction chamber in which the substrate is disposed when processing is effected, and a plasma shield plate separating the reaction chamber from the plasma generation chamber, the plasma shield plate being of electrically conductive material and having at least a hole for flowing the plasma into the reaction chamber and forming a portion of the plasma generation chamber. The microwave plasma processing apparatus further comprises a cover member disposed on a surface of the plasma shield plate facing the plasma generation chamber and made of material inactive with active species included in the plasma, for example quartz and alumina ceramic.

## Claims

1. Microwave plasma processing apparatus comprising a plasma generation chamber (3a), in which plasma can be generated by irradiating microwave power into a reactive gas introduced into the plasma generation chamber (3a), a reaction chamber (3b), and a plasma shield plate (6, 11) separating the reaction chamber (3a) from the plasma generation chamber (3b), the plasma shield plate being of electrically conductive material and having means (11a), e.g. a hole therein, allowing active species of the plasma to flow from the plasma generating chamber (3a) into the reaction chamber (3b), the plasma shield plate (6, 11) having a covering thereon;
characterised in that said covering is a separate cover member (21, 22) disposed on the surface of the plasma shield plate (6, 11) facing into the plasma generation chamber (3a), and made of material which is inactive with respect to active species included in the plasma generated in the apparatus when in use.

2. Apparatus as claimed in claim 1, wherein said cover member (21, 22) is of a material with which the recombination coefficient of the active species of the plasma is smaller than with the conductive material of the plasma shield plate (6, 11).

3. Apparatus as claimed in claim 1 or 2, wherein the electrically conductive material of the plasma shield plate (6, 11) is a metal comprising aluminium.

4. Apparatus as claimed in claim 1, 2 or 3, wherein the material of the cover member (21, 22) is quartz.

5. Apparatus as claimed in claim 1, 2 or 3, wherein the material of the cover member (21, 22) is alumina ceramic.

6. Apparatus as claimed in any preceding claim, wherein the reactive gas used to generate the plasma includes oxygen.

7. Apparatus as claimed in claim 6, wherein the reactive gas used to generate the plasma further includes fluoride containing gas or/and nitrogen gas.

8. Apparatus as claimed in any preceding claim, wherein the reaction chamber (3b) is partitioned to form a diffusion chamber (24) located adjacent the plasma shield plate (11), and the plasma shield plate providing an upper boundary of the diffusion chamber and a diffusion plate (23) providing a lower boundary thereof, the diffusion plate having a plurality of holes (23a) therein.

9. Apparatus as claimed in any preceding claim, wherein the cover member is greater than 1 mm thick.

10. Apparatus as claimed in claim 9, wherein the cover member is approximately 2 mm thick.

## Patentansprüche

1. Mikrowellen-lasmaverarbeitungsvorrichtung, mit einer Plasmaerzeugenden Kammer (3a), in der Plasma durch das Einstrahlen von Mikrowellenenergie in ein in die plasmaerzeugende Kammer (3a) eingebrachtes, reaktives Gas erzeugt werden kann, einer Reaktionskammer (3b) und einer Plasmaabschirmplatte (6, 11), welche die Reaktionskammer (3b) von der Plasmaerzeugenden Kammer (3a) trennt, wobei die Plasmaabschirmplatte aus einem elektrisch leitfähigen Material besteht und eine Einrichtung (11a), z.B. ein Loch darin, aufweist, die es ermöglicht, daß aktive Arten des Plasmas von der Plasmaerzeugenden Kammer (3a) in die Reaktionskammer (3b) strömen, wobei die Plasmaabschirmplatte (6, 11) eine Abdeckung darauf aufweist;
dadurch gekennzeichnet, daß die genannte Abdeckung ein getrennter Deckteil (21, 22) ist, der an der Oberfläche der Plasmaabschirmplatte (6, 11), die der plasmaerzeugenden Kammer (3a) zugewandt ist, angeordnet ist und aus einem Material besteht, das in bezug auf die aktiven Arten inaktiv ist, die im Plasma, das in der Vorrichtung erzeugt wird, wenn diese in Verwendung steht, enthalten sind.

2. Vorrichtung nach Anspruch 1, bei welcher der genannte Deckteil (21, 22) aus einem Material besteht, mit dem der Rekombinationskoeffizient der aktiven Arten des Plasmas kleiner ist als mit dem leitfähigen Material der Plasmaabschirmplatte (6, 11).

3. Vorrichtung nach Anspruch 1 oder 2, bei welcher das elektrisch leitfähige Material der Plasmaabschirmplatte (6, 11) ein Aluminium umfassendes Metall ist.

4. Vorrichtung nach Anspruch 1, 2 oder 3, bei welcher das Material des Deckteils (21, 22) Quarz ist.

5. Vorrichtung nach Anspruch 1, 2 oder 3, bei welcher das Material des Deckteils (21, 22) Aluminiumoxid-Keramik ist.

6. Vorrichtung nach einem der vorhergehenden Ansprüche, bei welcher das reaktive Gas, das zur Erzeugung des Plasmas verwendet wird, Sauerstoff enthält.

7. Vorrichtung nach Anspruch 6, bei welcher das reaktive Gas, das zur Erzeugung des Plasmas verwendet wird, ferner Gas oder/und Stickstoffgas enthält.

8. Vorrichtung nach einem der vorhergehenden Ansprüche, bei welcher die Reaktionskammer (3b) geteilt ist, um eine Diffusionskammer (24) zu bilden, die der plasmaabschirmplatte (11) benachbart angeordnet ist, wobei die Plasmaabschirmplatte eine obere Begrenzung der Diffusionskammer vorsieht, und eine Diffusionsplatte (23) eine untere Begrenzung davon vorsieht, welche Diffusionsplatte eine Vielzahl von Löchern (23a) darin aufweist.

9. Vorrichtung nach einem der vorhergehenden Ansprüche, bei welcher der Deckteil mehr als 1 mm dick ist.

10. Vorrichtung nach Anspruch 9, bei welcher der Deckteil ungefähr 2 mm dick ist.

## Revendications

1. Appareil de traitement par plasma micro-ondes, comprenant une chambre de production de plasma (3a), dans laquelle on peut engendrer un plasma en irradiant une puissance de micro-ondes dans un gaz réactif introduit dans la chambre de production de plasma (3a), une chambre de réaction (3b), et une plaque écran (6, 11) vis-à-vis du plasma, qui sépare la chambre de réaction (3b) par rapport à la chambre de production de plasma (3a), la plaque écran étant réalisé en matériau conducteur de l'électricité et comportant des moyens (11a), tels qu'un trou dans ladite plaque, permettant aux espèces actives du plasma de s'écouler depuis la chambre de production de plasma (3a) vers la chambre de réaction (3b), la plaque écran (6, 11) comportant une couverture ;
caractérisé en ce que ladite couverture est un élément de couverture séparé (21, 22) disposé sur la surface de la plaque écran (6, 11) qui fait face vers l'intérieur de la chambre de production de plasma (3a), et réalisée en un matériau qui est inactif par rapport aux espèces actives comprises dans le plasma engendré dans l'appareil en utilisation.

2. Appareil selon la revendication 1, dans lequel ledit élément de couverture (21, 22) est réalisé en un matériau avec lequel le coefficient de recombinaison des espèces actives du plasma est plus faible qu'avec le matériau conducteur de la plaque écran (6, 11).

3. Appareil selon l'une ou l'autre des revendications 1 et 2, dans lequel le matériau conducteur de l'électricité de la plaque écran (6, 11) est un métal qui comprend de l'aluminium.

4. Appareil selon l'une quelconque des revendications 1 à 3, dans lequel le matériau de l'élément de couverture (21, 22) est du quartz.

5. Appareil selon l'une quelconque des revendications 1 à 3, dans lequel le matériau de l'élément de couverture (21, 22) est de la céramique d'alumine.

6. Appareil selon l'une quelconque des revendications précédentes, dans lequel le gaz réactif utilisé pour engendrer le plasma comprend de l'oxygène.

7. Appareil selon la revendication 6, dans lequel le gaz réactif utilisé pour engendrer le plasma comprend en outre un gaz contenant un fluorure et/ou de l'azote gazeux.

8. Appareil selon l'une quelconque des revendications précédentes, dans lequel la chambre de réaction (3b) est cloisonnée pour former une chambre de diffusion (24) située adjacente à la plaque écran (11), et la plaque écran constituant une limite supérieure de la chambre de diffusion, et une plaque de diffusion (23) réalisant une limite inférieure de celle-ci, la plaque de diffusion comportant une pluralité de trous (23a).

9. Appareil selon l'une quelconque des revendications précédentes, dans lequel l'élément de couverture a une épaisseur supérieure à 1 mm.

10. Appareil selon la revendication 9, dans lequel l'élément de couverture a une épaisseur approximativement égale à 2 mm.
